# EUROPEAN PATENT SPECIFICATION

(11) **EP 0 398 607 B1**
(45) Date of publication and mention of the grant of the patent: **15.01.1997**
(21) Application number: 90305147.2
(22) Date of filing: 14.05.1990
(51) Int. Cl.: H05K 5/02, H01M 2/10

(54) **Battery operated personal terminal**
Batteriebetriebenes persönliches Terminalgerät
Terminal personnel alimenté par batterie

(30) Priority: 16.05.1989 JP 122259/89
(43) Date of publication of application: 22.11.1990
(73) Proprietor: KABUSHIKI KAISHA TOSHIBA, Kawasaki-shi, Kanagawa-ken 210 (JP)
(72) Inventor: Tanaka, Yoshinori, c/o Intellectual Property Div., Minato-ku, Tokyo (JP)
(74) Representative: Shindler, Nigel

(56) References cited:
- EP-A- 0 106 474
- DE-U- 7 245 574
- PATENT ABSTRACTS OF JAPAN vol. 11, no. 220 (E-524)(2667) 16 July 1987, & JP-A- 62 40154

## Description

The present invention relates to a portable apparatus and more particularly, to a battery operated portable data processing apparatus such as a terminal.

Many types of portable data-processing apparatus are known which may be used for a wide variety of financial, shopping, and other transactions. In addition portable terminal apparatus may be used in a data collecting system for collecting quality data from factory and sending the data to a host computer. Such portable terminals generally have a central processing unit, a display device, a keyboard, a memory, and a battery for providing predetermined voltage to the display device, the keyboard, the central processing unit, and the memory.

One known portable terminal apparatus has a battery insertion slot for receiving the battery, and a chamber for storing the battery, which has a recess in one end. The portable terminal apparatus also has a locking lever for projecting into the recess cut upon insertion of the battery, to lock the battery into a predetermined position. The lock lever was released from the recess when the other end of the lock lever was depressed. Accordingly, it was possible to lock and release the battery. However, if the insertion slot was pointed downward when the lock lever was released, the battery fell out and could be damaged.

Patent abstracts of Japan, Vol 11, No. 220, (E524), (2667) 16 July 1987 discloses when a battery mounted is taken out, a lever is slided. The lever turns counterclockwise the first locking member against the action of a spring to release one end of the locking member from the second locking member. In the second step, when the battery is pressed in against the action the action of a spring, the second locking member which is locked in an locking part turns clockwise by the action of a spring to release it from the locking part. Thereby, the battery can be taken out.

The present invention seeks to provide a battery operated portable terminal apparatus in which the battery is more securely retained.

Accordingly the present invention provides a battery operated portable apparatus, comprising:
a housing having an insertion aperture for receiving a battery; a battery having a recess therein; a pivotally mounted locking member having a first end portion for engagement with the recess to lock the battery in the insertion aperture, a spring being arranged to bias the pivotally mounted locking member so that its first end portion engages with the recess: the locking member being in the form of a lever having a second end portion which can be depressed; and the recess being provided with a detent for engagement with said first end portion of said locking member so that the locking member cannot move and such that the second end portion can only be depressed after the battery is moved further into the insertion slot to disengage the first end portion of the locking member from the detent, and further spring means for urging the battery in a direction outwardly of the housing, so as to urge it into engagement with the locking member.

Some embodiments of the invention will now be described by way of example with reference to the accompanying drawings in which:
Figure 1 is a schematic perspective view of a portable electronic apparatus according to the present invention;
Figure 2 is a sectional view showing a notch cut of the battery;
Figure 3 is a schematic front view showing the interior of a battery storing portion;
Figure 4(a) to Figure 4(c) are front views explaining the battery release operation;
Figure 5 to Figure 10 are sectional views explaining other embodiments of the present invention;
Figure 11 to Figure 12 are schematic front views explaining other embodiments of the present invention; and
Figure 13 is a block diagram of a portable electronic apparatus according to the present invention.

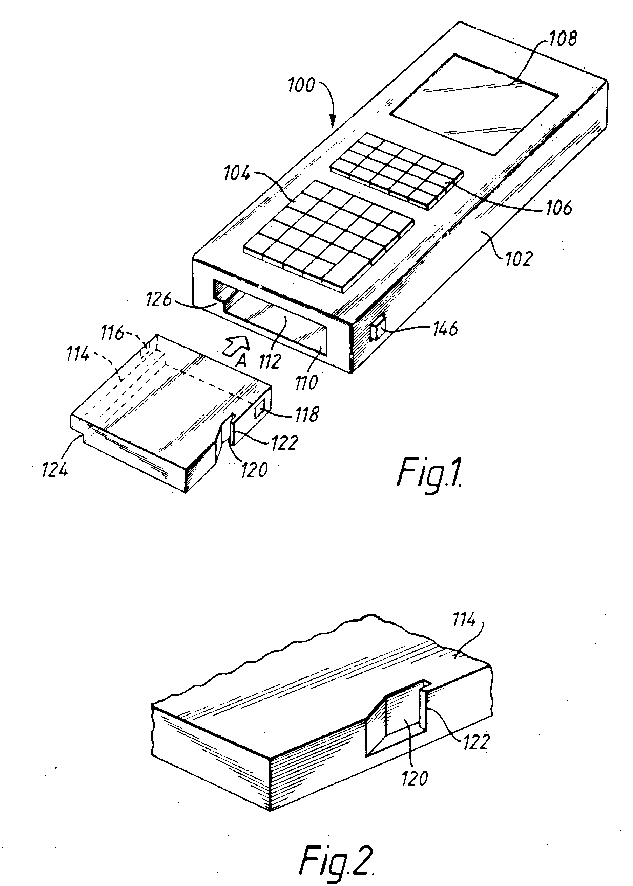

Figure 1 is a perspective view of a portable terminal apparatus 100 according to the present invention. The portable terminal apparatus 100 has a housing 102, a keyboard 104 and 106, and a display 108 such as a liquid crystal display. A battery chamber 112 is arranged at one end of the housing 102 chamber and has an insertion aperture 110.

A battery pack 114, including a nickel-cadmium battery, is formed in a rectangular shape. A pair of contacts 116 and 118 are arranged on opposite sides of the battery pack 114. A recess 120 is formed on one side of the battery pack 114. As shown in Figure 2, the recess has a re-entrant portion forming a detent 122 at one side. A step 124 is formed on the other side of the battery 114, and a corresponding ledge 126 is formed on the interior of the housing 102.

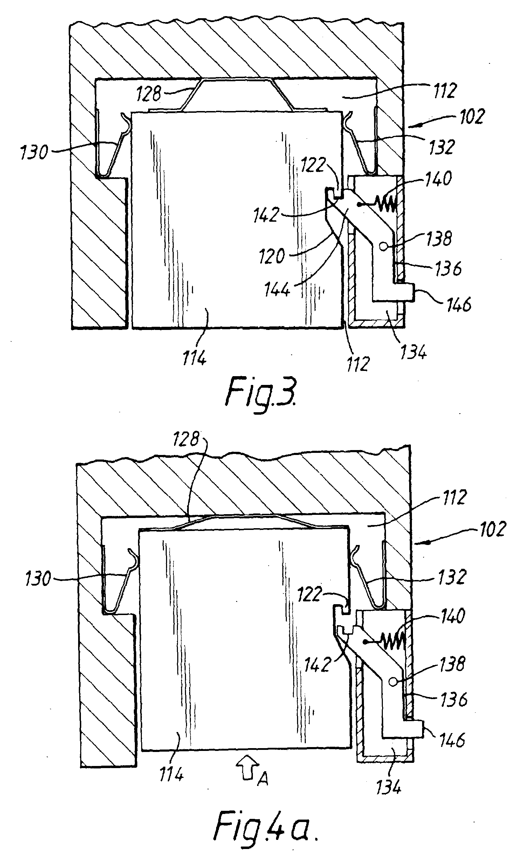

Figure 3 shows schematically, the interior of a portable terminal apparatus 100. A spring 128 is arranged at the inner end of the battery chamber 112 for urging the battery outwards. A pair of contacts 130 and 132 are arranged on opposite sides of battery chamber 122 for receiving predetermined voltage from the battery 114.

A locking device 134 is arranged on one side of the battery chamber against one side of inserted battery 114. The locking device 134 includes a latch lever 136 rotatably supported on a pivot 138, and a coil spring 140 for urging the lock lever 136 into a set position. An end portion 144 of the latch lever 136 engages with the recess 120. The end portion 144 is movable to project into the recess 120. A notch 142 is formed on the end portion 144. The other end of lock lever 136 projects outside of the housing 102 and forms a release button 146.

The latch lever 136 moves on insertion of the battery 114, the end portion 144 projects into the recess 120 due to the force of the coil spring 140. The spring 128 urges the battery 114 outwards so that the battery 114 moves to engage the notch 142 onto the detent 122 of the recess 120.

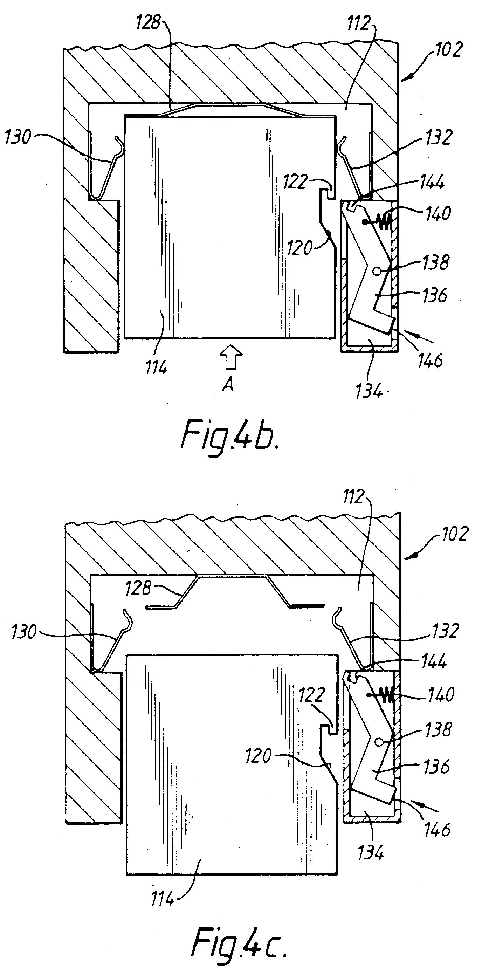

The process for releasing the battery 114 will be described with reference to Figure 3 and Figure 4(a) to Figure 4(b). As shown in Figure 3 the detent 122 is normally locked by the notch 142 when the battery is inserted, so that the latch lever 136 cannot move. When the battery 114 is moved in the insertion direction, the detent 122 leaves the notch 142 (as shown in Figure 4(a)). Thus, as shown in figure 4(b), the release button may be depressed and the battery 114 can be removed through the battery insertion slot 110 (as shown in Figure 4(c).

Thus, the battery 114 cannot be released only by depressing the release button, but only if the battery 114 is moved in a predetermined direction and the release button 146 then depressed. Thus, the battery 114 cannot be released by accident.

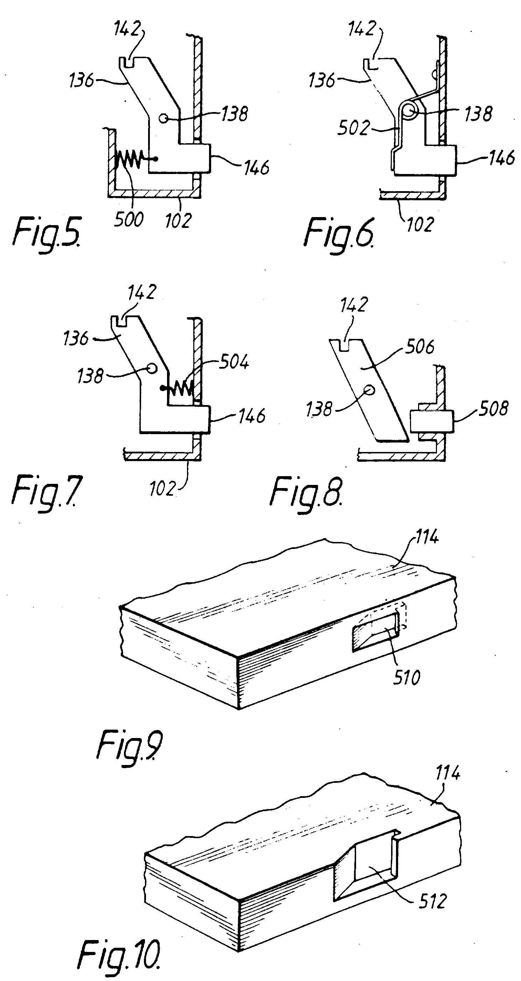

Other embodiments of the present invention will be described with reference to Figure 5 to Figure 12.

Figure 5 shows a second embodiment of the present invention. In this embodiment bias spring 500 is arranged between housing 102 and the other end of the lock lever 136.

Figure 6 shows a third embodiment of the present invention. In this embodiment, the bias for the lever 136 is provided by a wire or leaf spring 502 arranged around the pivot shaft 138. One end of the leaf spring 502 is fixed on the housing 102 and another end of the leaf spring 502 is fixed on the latch lever 136.

Figure 7 shows a fourth embodiment of the present invention. In this embodiment, a coil spring 504 is arranged between housing 102 and a lower position of the latch lever 136.

Figure 8 shows a fifth embodiment of the present invention. In this embodiment a latch lever 506 and a release, button 508 are separately mounted in housing 102.

Figure 9 shows a sixth embodiment of the present invention. In this embodiment, a recess 510 extends partially across the width of the battery 114.

Figure 10 shows a seventh embodiment of the present invention. In this embodiment, a recess 512 is formed on the battery 114, opening to the upper surface of the battery.

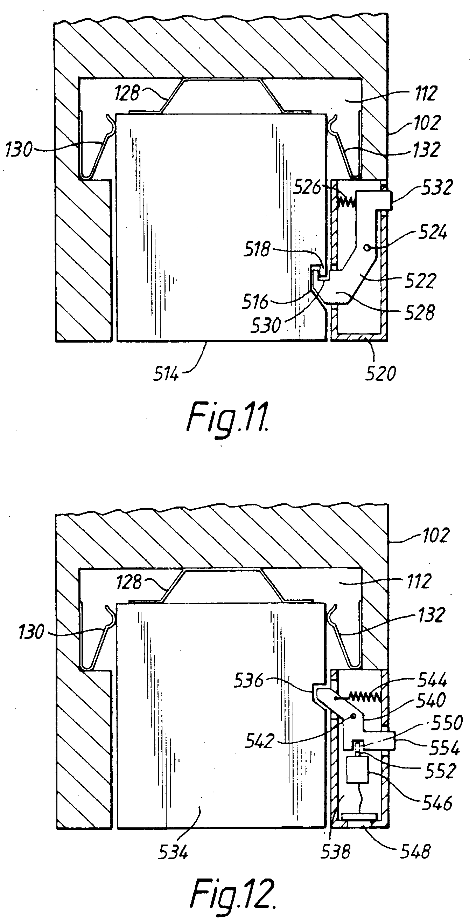

Figure 11 shows a eighth embodiment of the present invention. In this embodiment, the battery 514 has a recess 516 on the lower part of one side. A detent 518 is disposed at the upper side of the recess 516.

A locking device 520 is arranged at one side of the battery chamber 102 adjacent one side of inserted battery 514. The locking device 520 includes a latch lever 522 rotatably supported by shaft 524, and coil spring 526 for urging the lever 522 into a locked position. The lower end portion 528 of the latch lever 522 abuts adjacent recess 516 of the battery and the lower end portion 528 has a notch 536 which engages with detent 518 of the recess. The other end of latch lever 522 projects outside of housing 102 and forms a release button 530.

Figure 12 showing a ninth embodiment of the present invention. In this embodiment, the battery 534 has recess 536 on one side.

A locking device 538 is arranged at a side of housing 102, and engages the side of inserted battery 532. The locking device 536 includes a latch lever 540 rotatably supported by shaft 542, a coil spring 544 for urging the latch lever 540 into a locked position, a solenoid 546 and a detector 548. The latch lever 540 includes a notch 550 and the solenoid 546 includes a detent member 552. Detector 548 detects whether an external object is located against the lower surface of the battery. The solenoid 550 receives a signal from detector 552 and when an external object is against near the battery, the solenoid retracts the detent 552 to release the battery. Thus, the battery 114 can then be released when release button 554 is depressed.

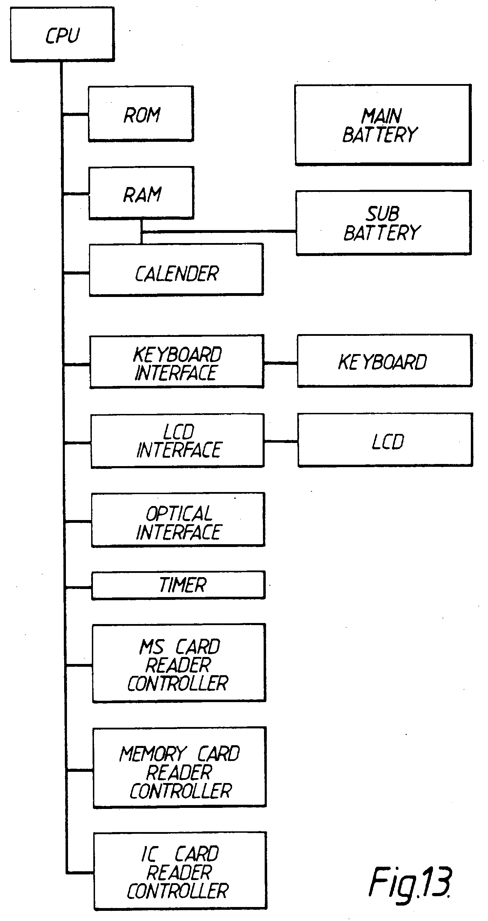

A block diagram of a portable electronic apparatus according to the present invention is arranged as shown in Figure 13.

The circuit of the portable electronic apparatus comprises a central processing unit (CPU) 600, a read only memory (rom) 602, random access memory (RAM) 604, calendar unit 606, keyboard interface 608, keyboard 610, liquid crystal display (LCD) interface 612, liquid crystal display (LCD) 614, optical interface 616, timer unit 618, magnet stripe (Ms) card reader controller 620, memory card reader controller 622, IC card reader controller 624, sub-battery 626, main battery 626. The main battery 626 provides predetermined voltage to each of the units when a power-on switch (not shown) is depressed. The sub-battery 624 provides a constant predetermined voltage to the RAM 604 and calendar unit 606.

## Claims

1. A battery operated portable apparatus, comprising:
a housing having an insertion aperture (112) for receiving a battery;
a battery (114, 514) having a recess (120, 536) therein;
a pivotally mounted locking member (136, 522) having a first end portion for engagement with the recess to lock the battery in the insertion aperture,
a spring (140) arranged to bias the pivotally mounted locking member (136, 522) so that its first end portion engages with the recess;
the locking member being in the form of a lever having a second end portion (146,532) which can be depressed;
the recess (120, 536) being provided with a detent (122,518) for engagement with said first end portion (144,528) of said locking member so that the locking member cannot move and such that the second end portion can only be depressed after the battery is moved further into the insertion slot to disengage the first end portion of the locking member from the detent; and
further spring means (128) for urging the battery in a direction outwardly of the housing, so as to urge it into engagement with the locking member.

2. A battery operated portable apparatus as claimed in claim 1, wherein said end portion has a notch (142) therein to receive the detent.

3. A battery operated portable apparatus as claimed in claim 1 or 2, wherein the recess (120,536) is re-entrant providing said detent (122,518) on one side of the battery.

4. A battery operated portable apparatus according to claim 3 wherein said locking member is arranged for latching engagement in said recess.

5. A battery operated portable apparatus according to claim 4, in which the engaging portion of said re-entrant recess faces towards the aperture, whilst the cooperating engaging portion of said latching means faces in the opposite direction and is resiliently biassed into engagement with the recess; whereby the battery must be moved further into the housing to enable disengagement of said locking member.

## Patentansprüche

1. Batteriebetriebenes, tragbares Gerät mit
einem Gehäuse mit einer Einführöffnung (112) zur Aufnahme einer Batterie;
einer Batterie (114, 514) mit einer Aussparung (120, 536);
einem schwenkbar befestigten Verriegelungselement (136, 522) mit einem ersten Endbereich für den Eingriff mit der Aussparung, um die Batterie in der Einführöffnung zu verriegeln,
einer Feder (140) zur Beaufschlagung des schwenkbar befestigten Verriegelungselementes (136, 522), so daß sein erster Endbereich in Eingriff mit der Aussparung steht, wobei das Verriegelungselement in Form eines Hebels einen zweiten Endbereich (146, 532) aufweist, der eindrückbar ist, und
die Aussparung (120, 536) mit einem Anschlag (122, 518) zum Eingriff mit dem ersten Endbereich (144, 528) des Verriegelungselementes versehen ist, so daß sich das Verriegelungselement nicht bewegen kann und so daß der zweite Endbereich nur eindrückbar ist, nachdem die Batterie weiter in den Einführschlitz hineinbewegt ist, um den ersten Endbereich des Verriegelungselementes außer Eingriff mit dem Anschlag zu bringen, und
ferner mit Federmitteln (128), um die Batterie in Richtung aus dem Gehäuse zu belasten, so daß sie in Eingriff mit dem Verriegelungselement gedrückt wird.

2. Batteriebetriebenes, tragbares Gerät nach Anspruch 1, bei dem der Endbereich einen Schlitz (142) zur Aufnahme des Anschlags aufweist.

3. Batteriebetriebenes, tragbares Gerät nach Anspruch 1 oder 2, bei dem die Aussparung (120, 536) nach innen gerichtet ist und den Anschlag (122, 518) an einer Seite der Batterie bildet.

4. Batteriebetriebenes, tragbares Gerät nach Anspruch 3, bei dem das Verriegelungselement zum verriegelnden Eingriff in die Aussparung angeordnet ist.

5. Batteriebetriebenes, tragbares Gerät nach Anspruch 4, bei dem der Eingriffsbereich der nach innen gerichteten Aussparung der Öffnung zugewandt ist, während der zusammenwirkende Eingriffsbereich der Verriegelungsmittel in entgegengesetzter Richtung gerichtet ist und elastisch in Eingriff mit der Aussparung gedrückt wird, so daß die Batterie weiter in das Gehäuse bewegt werden muß, um ein Außereingriffbringen des Verriegelungselementes zu bewirken.

## Revendications

1. Appareil portable alimenté par batterie, comprenant :
un boîtier ayant une ouverture d'insertion (112) pour recevoir une batterie ;
une batterie (114, 514) comportant un creux (120, 536) ;
un élément de verrouillage monté de manière pivotante (136, 522) ayant une première partie d'extrémité pour se mettre en prise avec le creux pour verrouiller la batterie dans l'ouverture d'insertion,
un ressort à spirale (140) agencé pour presser l'élément de verrouillage monté de manière pivotante (136, 532) de telle sorte que sa première partie d'extrémité se met en prise avec le creux ;
l'élément de verrouillage étant sous la forme d'un levier ayant une seconde partie d'extrémité (146, 532) qui peut être pressée ;
le creux (120, 536) étant muni d'un cliquet (122, 518) pour se mettre en prise avec ladite première partie d'extrémité (144, 528) dudit élément de verrouillage de telle sorte que l'élément de verrouillage ne puisse pas bouger et de telle sorte que la seconde partie d'extrémité puisse être seulement pressée après que la batterie a été déplacée plus avant dans la fente d'insertion pour désolidariser la première partie d'extrémité de l'élément de verrouillage du cliquet ; et
d'autres moyens de ressort (128) pour presser la batterie dans une direction à l'extérieur du boîtier, de sorte à la presser en prise avec l'élément de verrouillage.

2. Appareil portable alimenté par batterie selon la revendication 1, dans lequel ladite partie d'extrémité comporte une encoche (142) pour recevoir le cliquet.

3. Appareil portable alimenté par batterie selon la revendication 1 ou 2, dans lequel le creux (120, 506) est rentrant, fournissant ledit cliquet (122, 518) sur un côté de la batterie.

4. Appareil portable alimenté par batterie selon la revendication 3, dans lequel ledit élément de verrouillage est agencé pour une mise en prise par verrouillage dans ledit creux.

5. Appareil portable alimenté par batterie selon la revendication 4, dans lequel la partie de mise en prise dudit creux rentrant fait face à l'ouverture, tandis que la partie de mise en prise fonctionnant de concert desdits moyens de verrouillage se trouve en face dans la direction opposée et est pressée de manière élastique en prise avec le creux ; moyennant quoi la batterie doit être déplacée plus avant dans le boîtier pour permettre une désolidarisation dudit élément de verrouillage.
